# EUROPEAN PATENT SPECIFICATION

(11) **EP 4 369 011 B1**
(45) Date of publication and mention of the grant of the patent: **09.09.2026**
(21) Application number: 22936205.8
(22) Date of filing: 08.04.2022
(51) Int. Cl.: G01R 31/36, G01R 31/3835, G01R 31/396, G01R 31/364, G01R 31/52

(54) **BATTERY CELL SHORT CIRCUIT IDENTIFICATION METHOD AND APPARATUS, BMS, BATTERY PACK, DEVICE AND MEDIUM**
VERFAHREN UND VORRICHTUNG ZUR IDENTIFIZIERUNG EINES BATTERIEZELLENKURZSCHLUSSES, BMS, BATTERIEPACK, VORRICHTUNG UND MEDIUM
PROCÉDÉ ET APPAREIL D'IDENTIFICATION DE COURT-CIRCUIT DE CELLULE DE BATTERIE, SGB, BLOC-BATTERIE, DISPOSITIF ET SUPPORT

(43) Date of publication of application: 15.05.2024
(73) Proprietor: Contemporary Amperex Technology (Hong Kong) Limited, Central, Central And Western District (HK)
(72) Inventor: XIE, Lan, Ningde, Fujian 352100 (CN); LIN, Shiliang, Ningde, Fujian 352100 (CN); LIN, Zhen, Ningde, Fujian 352100 (CN); SONG, Shuai, Ningde, Fujian 352100 (CN); LI, Wei, Ningde, Fujian 352100 (CN); LI, Zhonghong, Ningde, Fujian 352100 (CN); WU, Kai, Ningde, Fujian 352100 (CN)
(74) Representative: Ziebig Hengelhaupt Intellectual Property Attorneys Patentanwaltskanzlei PartGmbB
(86) International application number: PCT/CN2022/085964
(87) International publication number: WO 2023/193268

(56) References cited:
- CN-A- 111 913 113
- CN-A- 112 653 204
- CN-A- 112 653 204
- CN-A- 113 125 997
- CN-A- 113 675 489
- CN-A- 113 884 886
- US-A1- 2009 108 808
- US-A1- 2016 377 667
- US-A1- 2019 277 916
- US-A1- 2019 305 384
- US-A1- 2020 025 832

## Description

### TECHNICAL FIELD

This application relates to the field of batteries, in particular to an electrode assembly short circuit identification method and apparatus, a BMS, a battery pack, a device and a medium.

### BACKGROUND

A negative electrode of a lithium-ion electrode assembly is mainly made of a graphite carbon material, and during low-temperature charging or high-rate charging, large polarization occurs in the electrode assembly. Continuous polarization is likely to cause lithium precipitation of the electrode assembly to form lithium dendrites, and the lithium dendrites may puncture a separator, resulting in a short circuit between a positive electrode and a negative electrode in the electrode assembly. When the short circuit area expands to some extent, thermal runaway may be triggered, resulting in serious battery safety accidents. Therefore, it is necessary to judge in advance whether a short circuit occurs in the electrode assembly.

At present, the most commonly used method for judging whether a short circuit occurs in an electrode assembly is: disassembling the electrode assembly to visually judge the severity of lithium precipitation in the electrode assembly and providing a conclusion. However, in this method, the electrode assembly needs to be disassembled; the disassembling of the electrode assembly brings some potential safety hazards and also consumes lots of labor and material resources; and the solution is high in implementation cost and low in efficiency, which is not conducive to the popularization in industrial application. In addition, the solution mainly depends on experience judgment of a person, and there are also errors caused by subjective judgment, resulting in low reliability. CN112653204A discloses a battery system including: a battery module including a plurality of battery sub modules connected in parallel between system terminals; a plurality of switches connected in series to the plurality of battery sub modules, respectively; a measuring unit measuring voltage values of the battery module and/or cells included in the battery module and current values which flow on the battery modules; a detecting unit determining whether or not an internal short occurs in the plurality of battery sub modules by monitoring the voltage values or the current values; and a control unit controlling, when the internal short occurs in at least one battery sub module of the plurality of battery sub modules, at least one switch corresponding to the at least one battery sub module among the plurality of switches in a non-conductive state. US2009108808A1 discloses methods and systems for detecting internal battery abnormalities during charging and discharging states. The systems include a circuit for determining charging and/or discharging state of the battery, a circuit for sampling the battery voltage at sequential time points, a circuit for measuring the decline of the voltage, a counter for counting Tdec the time while the voltage is in decline, a circuit for measuring the rate of the decrease of the voltage, a circuit for producing an indicator for internal abnormality if one or more of the following conditions is met: (a) the battery is in the charging state and Tdec exceeds a predetermined time; (b) the battery is in the charging state and the decrease of the voltage exceeds a predetermined voltage; and (c) the battery is in the discharging state and the rate of the decrease of the voltage exceeds a predetermined decline rate. US2020025832A1 discloses a method for detecting an internal short of a battery, the method includes: measuring a voltage of a battery a plurality of times; and determining whether or not the internal short of the battery occurs based on a difference between a first voltage value of the battery during a first time period and a second voltage value of the battery during a second time period when the battery is in constant current charging, wherein the second time period is a time period after the first time period.

### SUMMARY

This application are intended to provide an electrode assembly short circuit identification method and apparatus, a BMS, a battery pack, a device and a medium, so as to improve short circuit identification efficiency and identification reliability in electrode assemblies.

According to a first aspect, this application provides an electrode assembly short circuit identification method including: according to preset sampling time points, sequentially acquiring a voltage at each of the sampling time points during charging of an electrode assembly; judging whether the electrode assembly has a continuous voltage drop according to the voltage acquired at each of the sampling time points; and determining whether the electrode assembly has a short circuit according to a judgment result.

In actual use, a normal electrode assembly is considered to have a continuous voltage rise during charging. However, once a short circuit occurs in the electrode assembly, that is, positive and negative electrodes in the electrode assembly are connected to each other, an abnormal voltage drop of the electrode assembly is caused. On the basis of this mechanism, in the technical solution of the embodiments of this application, whether the electrode assembly has a short circuit can be determined quickly by judging whether the electrode assembly has a continuous voltage drop during charging. As compared with an existing solution, the electrode assembly does not need to be disassembled, the solution is featured with low implementation cost and higher efficiency, and in addition, the identification result is no longer judged depending on experience of a person, and therefore there is no error caused by subjective judgment, resulting in higher reliability.

In some embodiments, the determining whether the electrode assembly has a short circuit according to a judgment result includes: determining that the electrode assembly has a short circuit under a condition that the electrode assembly has a continuous voltage drop.

In the foregoing technical solution, the determining that the electrode assembly has a short circuit under a condition that the electrode assembly has a continuous voltage drop can ensure that a short circuit of the electrode assembly can be effectively discovered, avoiding serious battery safety accidents caused by the short circuit of the electrode assembly.

In some embodiments, the determining whether the electrode assembly has a short circuit according to a judgment result includes: under a condition that the electrode assembly has a continuous voltage drop, judging whether or not a continuous voltage drop amplitude of the electrode assembly is greater than a preset voltage fluctuation range; and if the continuous voltage drop amplitude of the electrode assembly is greater than the preset voltage fluctuation range, determining that the electrode assembly has a short circuit.

Considering that in actual use, during voltage acquisition of an electrode assembly, acquired data may fluctuate to some extent due to limitation of acquisition accuracy of an acquisition device, a situation that the electrode assembly is normal but an acquired voltage of the electrode assembly shows a small continuous drop may occur. In the foregoing technical solution, with the preset voltage fluctuation range, the electrode assembly is determined to have a short circuit under a condition that a continuous voltage drop amplitude of the electrode assembly is greater than the voltage fluctuation range. This can exclude a case of continuous voltage drop of the electrode assembly caused by the acquisition accuracy of the acquisition device, thereby reducing mis-identification and improving the reliability for identifying whether the electrode assembly has a short circuit.

In some embodiments, the voltage fluctuation range is voltage acquisition accuracy of a battery management system.

In the foregoing technical solution, the voltage fluctuation range is set to be the voltage acquisition accuracy of the battery management system, thereby excluding a case of continuous voltage drop of the electrode assembly caused by the acquisition accuracy of the acquisition device as well as identifying a short circuit of the electrode assembly in time, reducing the risk of missing inspection of a short circuit of the electrode assembly and improving the reliability for identifying whether the electrode assembly has a short circuit.

In the first aspect, the determining whether the electrode assembly has a continuous voltage drop according to the voltage acquired at each of the sampling time points includes: under a condition that the voltage of the electrode assembly is acquired at a current sampling time point, judging whether or not the voltage at the current sampling time point is lower than a voltage at a previous sampling time point that the current sampling time point follows; if the voltage at the current sampling time point is lower than the voltage at the previous sampling time point that the current sampling time point follows, judging whether a marked sampling time point is present; if no marked sampling time point is present, marking the previous sampling time point; and if a marked sampling time point is present, determining that the electrode assembly has a continuous voltage drop from the marked sampling time point to the current sampling time point.

In the foregoing technical solution, under the condition that a voltage drop occurs, the sampling time point is marked, such that whether the electrode assembly has a continuous voltage drop can be determined quickly according to whether a marked sampling time point is present. The solution is simple in implementation and high in efficiency.

In some embodiments, the method further includes: if the voltage at the current sampling time point is higher than or equal to the voltage at the previous sampling time point that the current sampling time point follows, judging whether a marked sampling time point is present; and if a marked sampling time point is present, deleting the mark of the sampling time point.

In the foregoing technical solution, after a voltage rise is detected, an existing mark of the sampling time point is deleted to ensure that whether the electrode assembly has a continuous voltage drop can be determined accurately based on whether the marked sampling time point is present, and the reliability of the solution is ensured.

In some embodiments, the determining whether the electrode assembly has a short circuit according to a judgment result includes: under a condition that the electrode assembly has a continuous voltage drop, calculating a difference value between a voltage at the marked sampling time point and the voltage at the current sampling time point; judging whether the difference value is greater than the preset voltage fluctuation range; and if the difference value is greater than the preset voltage fluctuation range, determining that the electrode assembly has a short circuit.

In the foregoing technical solution, as long as it is still determined that the electrode assembly has a continuous voltage drop at the current sampling time point, the difference value between the voltage at the marked sampling time point and the voltage at the current sampling time point is calculated (that is, a continuous voltage drop amplitude when the voltage continuously drops to the voltage at the current sampling time point), thereby judging whether the electrode assembly has a short circuit. In this way, once a continuous voltage drop amplitude at a latest sampling time point is greater than the preset voltage fluctuation range, it can be determined that the electrode assembly has a short circuit, thereby achieving the effect of discovering a short circuit of the electrode assembly in time.

In some embodiments, a time interval between adjacent two of the sampling time points is less than or equal to 0.1 second.

Theoretically, a shorter time interval between adjacent two of the sampling time points indicates a higher voltage sampling frequency for the electrode assembly, such that whether the electrode assembly has a continuous drop during charging can be discovered more easily. In the foregoing technical solution, the applicants have found through lots of actual tests that under a condition that the time interval between adjacent two of the sampling time points is less than or equal to 0.1 second, a case of a continuous voltage drop caused by a short circuit of the electrode assembly can be effectively discovered, achieving desirable electrode assembly short circuit identification reliability.

In some embodiments, the method further includes: after determining that the electrode assembly has a short circuit, stopping charging of all battery groups; or after determining that the electrode assembly has a short circuit, stopping charging of a battery group where the electrode assembly is located.

In the foregoing technical solution, after it is determined that the electrode assembly has a short circuit, charging of all the battery groups is stopped, or charging of the battery group where the electrode assembly is located is stopped, thereby effectively reducing the possibility of battery safety accidents triggered by a short circuit of the electrode assembly during charging and improving the safety during charging.

In some embodiments, the method further includes: after determining that the electrode assembly has a short circuit, marking the electrode assembly.

In the foregoing technical solution, the electrode assembly having a short circuit is marked, thereby helping an engineer to perform processing such as disassembling and replacement on the electrode assembly in the battery group later.

According to a second aspect, this application further provides an electrode assembly short circuit identification apparatus, including: an acquisition module, configured to sequentially acquire, according to preset sampling time points, a voltage at each of the sampling time points during charging of an electrode assembly; and a judging module, configured to judge whether the electrode assembly has a continuous voltage drop according to the voltage acquired at each of the sampling time points and determine whether the electrode assembly has a short circuit according to a judgment result, wherein the electrode assembly short circuit identification apparatus is configured to implement the method of the first aspect.

In some embodiments, the judging module is specifically configured to: determine that the electrode assembly has a short circuit under a condition that the electrode assembly has a continuous voltage drop.

In some embodiments, the judging module is specifically configured to: under a condition that the electrode assembly has a continuous voltage drop, judge whether or not a continuous voltage drop amplitude of the electrode assembly is greater than a preset voltage fluctuation range; and if the continuous voltage drop amplitude of the electrode assembly is greater than the preset voltage fluctuation range, determine that the electrode assembly has a short circuit.

In some embodiments, the voltage fluctuation range is voltage acquisition accuracy of a battery management system.

In some embodiments, the judging module is specifically configured to: under a condition that the voltage of the electrode assembly is acquired at a current sampling time point, judge whether or not the voltage at the current sampling time point is lower than a voltage at a previous sampling time point that the current sampling time point follows; if the voltage at the current sampling time point is lower than the voltage at the previous sampling time point that the current sampling time point follows, judge whether a marked sampling time point is present; if no marked sampling time point is present, mark the previous sampling time point; and if a marked sampling time point is present, determine that the electrode assembly has a continuous voltage drop from the marked sampling time point to the current sampling time point.

In some embodiments, the judging module is further configured to: if the voltage at the current sampling time point is higher than or equal to the voltage at the previous sampling time point that the current sampling time point follows, judge whether a marked sampling time point is present; and if a marked sampling time point is present, delete the mark of the sampling time point.

In some embodiments, the judging module is specifically configured to: under a condition that the electrode assembly has a continuous voltage drop, calculate a difference value between a voltage at the marked sampling time point and the voltage at the current sampling time point; judge whether the difference value is greater than the preset voltage fluctuation range; and if the difference value is greater than the preset voltage fluctuation range, determine that the electrode assembly has a short circuit.

In some embodiments, a time interval between adjacent two of the sampling time points is less than or equal to 0.1 second.

In some embodiments, the electrode assembly short circuit identification apparatus further includes a control module, configured to stop charging of all battery groups after determining that the electrode assembly has a short circuit; or configured to stop charging of a battery group where the electrode assembly is located after determining that the electrode assembly has a short circuit.

In some embodiments, the electrode assembly short circuit identification apparatus further includes a marking module, configured to mark the electrode assembly after determining that the electrode assembly has a short circuit.

According to a third aspect, this application further provides a battery management system, BMS including the electrode assembly short circuit identification apparatus of the second aspect, wherein the acquisition module is a battery sampling chip, configured to connect to each electrode assembly of a battery group. The judging module is a control chip in communication connection with the battery sampling chip.

In some embodiments, the control chip is further configured to execute a preset program instruction so as to implement any one of the foregoing electrode assembly short circuit identification methods.

According to a fourth aspect, this application further provides a battery pack, including: a battery group and any one of the foregoing battery management systems, where the battery group includes a plurality of electrode assemblies, and each of the electrode assemblies is connected to a battery sampling chip of the battery management system.

According to a fifth aspect, this application further provides an electric device, including the foregoing battery pack.

According to a sixth aspect, this application further provides a computer-readable storage medium, where the computer-readable storage medium stores one or more program instructions, and the one or more program instructions when executed by the battery management system of the third aspect, cause the battery management system to perform any one of the foregoing electrode assembly short circuit identification methods.

### BRIEF DESCRIPTION OF DRAWINGS

In order to describe the technical solutions in the embodiments of this application more clearly, the following briefly describes the accompanying drawings required for the embodiments of this application. It should be understood that the accompanying drawings below only show some embodiments of this application and thus should not be considered as a limitation on the scope. Persons of ordinary skill in the art may still derive other related drawings according to these accompanying drawings without creative efforts.
FIG. 1 is a schematic structural diagram of a battery cell according to an embodiment of this application;
FIG. 2 is a schematic structural diagram of a battery pack according to an embodiment of this application;
FIG. 3 is a flowchart of an electrode assembly short circuit identification method according to an embodiment of this application;
FIG. 4 is a schematic diagram of a voltage change of an electrode assembly during charging according to an embodiment of this application;
FIG. 5 is a schematic structural diagram of an electrode assembly short circuit identification apparatus according to an embodiment of this application; and
FIG. 6 is a schematic structural diagram of a vehicle according to an embodiment of this application.

### DETAILED DESCRIPTION OF EMBODIMENTS

The following describes in detail the embodiments of the technical solutions of this application with reference to the accompanying drawings. The following embodiments are merely intended for a clearer description of the technical solutions of this application and therefore are used as just examples.

Unless otherwise defined, all technical and scientific terms used herein shall have the same meanings as commonly understood by persons skilled in the art to which this application belongs. The terms used herein are intended to merely describe the specific embodiments rather than to limit this application. The terms "comprise", "include", and any other variations thereof in the specification, claims and brief description of drawings of this application are intended to cover non-exclusive inclusions.

In the description of the embodiments of this application, the technical terms "first", "second", and the like are merely used to distinguish between different objects, and shall not be construed as any indication or implication of relative importance or any implicit indication of the quantity, particular sequence or primary-secondary relationship of the technical features indicated. In the description of the embodiments of this application, "a plurality of" means more than two (including two) unless otherwise specifically stated.

In this specification, reference to "embodiment" means that specific features, structures or characteristics described with reference to the embodiment may be incorporated in at least one embodiment of this application. The word "embodiment" appearing in various positions in the specification does not necessarily refer to the same embodiment or an independent or alternative embodiment that is exclusive of other embodiments. It is explicitly or implicitly understood by persons skilled in the art that the embodiments described herein may be combined with other embodiments.

In the descriptions of the embodiments of this application, the term "and/or" describes only an association relationship for describing associated objects and represents that three relationships may exist. For example, A and/or B may represent: the following three cases: only A alone, both A and B, and only B alone. In addition, the character "/" in this specification generally indicates an "or" relationship between contextually associated objects.

Currently, from a perspective of market development, application of traction batteries is becoming more and more extensive. The traction batteries are widely used not only in energy storage power supply systems such as hydraulic, thermal, wind and solar power plants, but also in the fields of electric transportation tools such as electric bicycles, electric motorcycles and electric vehicles.

However, in these fields, the most commonly used traction batteries are lithium-ion batteries (that is, batteries formed by lithium-ion electrode assemblies). The applicants have noted that at present, a negative electrode of a lithium-ion electrode assembly is mainly made of a graphite carbon material; during low-temperature charging or high-rate charging, large polarization occurs in the electrode assembly; continuous polarization is likely to cause lithium precipitation of the electrode assembly to form lithium dendrites, and the lithium dendrites may puncture a separator, resulting in a short circuit between a positive electrode and a negative electrode in the electrode assembly; and when the short circuit area expands to some extent, thermal runaway may be triggered, resulting in serious battery safety accidents. Therefore, it is necessary to judge in advance whether a short circuit occurs in the electrode assembly.

The applicants have further noted that at present, the most commonly used method for judging whether a short circuit occurs in an electrode assembly is: disassembling the electrode assembly to visually judge the severity of lithium precipitation in the electrode assembly and providing a conclusion. However, in this solution, the electrode assembly needs to be disassembled; the disassembling of the electrode assembly brings some potential safety hazards and also consumes lots of labor and material resources; and the solution is high in implementation cost and low in efficiency, which is not conducive to the popularization in industrial application. In addition, the solution mainly depends on experience judgment of a person, and there are also errors caused by subjective judgment, resulting in low reliability.

Besides, the applicants have further noted that in actual use, during charging of a normal electrode assembly (that is, an electrode assembly with no short circuit), the voltage of the electrode assembly is in one-to-one correspondence to the state of charge, SOC of the electrode assembly. During charging of the electrode assembly, lithium ions are deintercalated from a positive electrode, and this process corresponds to a potential rise of the positive electrode of the electrode assembly. Whereas in a negative electrode of the electrode assembly, lithium ions are intercalated into graphite carbon, and a potential of the negative electrode drops during intercalation of the lithium ions. Voltage of electrode assembly=positive electrode potential-negative electrode potential. Therefore, a normal electrode assembly inevitably has a voltage rise during charging.

Lithium precipitation usually happens during charging. If lithium precipitation occurs in the electrode assembly during charging, lithium dendrites are formed and puncture a separator, resulting in a short circuit between the positive and negative electrodes in the electrode assembly, and the electrode assembly shows a self-discharge phenomenon. Thus, an abnormal continuous voltage drop occurs during charging.

On the basis of the foregoing discoveries, in order to improve short circuit identification efficiency and identification reliability in electrode assemblies, the applicants, through in-depth research, have designed an electrode assembly short circuit identification method, in which whether the electrode assembly has a short circuit can be determined quickly by judging whether the electrode assembly has a continuous voltage drop during charging. Therefore, as compared with an existing solution, the electrode assembly does not need to be disassembled, the solution is featured with low implementation cost and higher efficiency, and in addition the identification result is no longer determined depending on experience judgment of a person, and therefore there is no error caused by subjective judgment, resulting in higher reliability.

For ease of understanding of the solution of the embodiments of this application, the following firstly describes some basic information involved in the embodiments of this application.

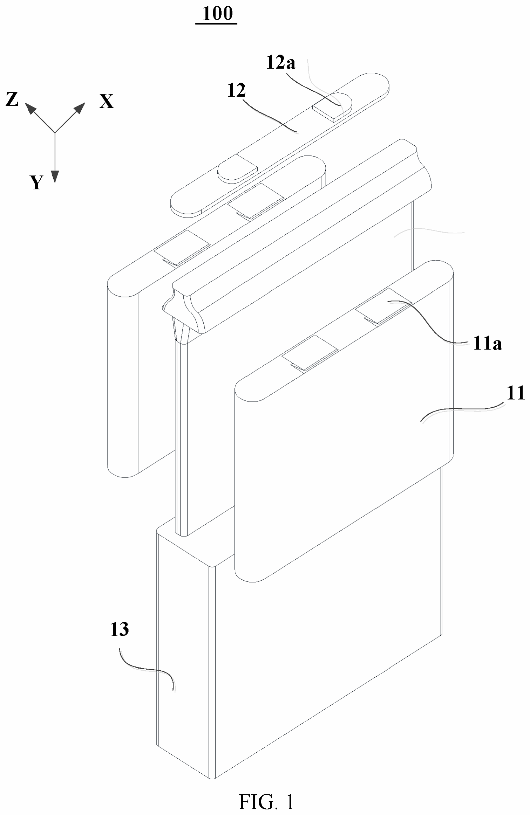

In actual industrial application, as shown in FIG. 1, an electrode assembly 11 may, together with an end cover 12, a housing 13 and other functional components, form a battery cell 100; where
the end cover 12 refers to a component that covers an opening of the housing 13 to isolate an internal environment of the battery cell 100 from an external environment. Without limitation, the end cover 12 may adapt to the housing 13 in shape so as to fit the housing 13. Optionally, the end cover 12 may be made of a material with specified hardness and strength (for example, an aluminum alloy). Thus, the end cover 12 is less likely to deform when subjected to extrusion and collision, allowing the battery cell 100 to have higher structural strength and improved safety performance. Functional components such as an electrode terminal 12a may be provided on the end cover 12. The electrode terminal 12a may be configured to be electrically connected to the electrode assembly 11 so as to output or input electrical energy of the battery cell 100. In some embodiments, the end cover 12 may further be provided with a pressure relief mechanism configured to release internal pressure when the internal pressure or a temperature of the battery cell 100 reaches a threshold. The end cover 12 may also be made of various materials, such as copper, iron, aluminum, stainless steel, aluminum alloy, and plastic, which are not particularly limited in the embodiments of this application. In some embodiments, an insulating member may also be provided at an inner side of the end cover 12. The insulating member may be configured to isolate an electrically connected component in the housing 13 from the end cover 12 to reduce the risk of short circuit. For example, the insulating member may be made of plastic, rubber, or the like.

The housing 13 is a component configured to fit the end cover 12 to form the internal environment of the battery cell 100, where the internal environment formed may be used to contain the electrode assembly 11, an electrolyte and other components. The housing 13 and the end cover 12 may be separate components, the opening may be provided on the housing 13, and the end cover 12 covers the opening to form the internal environment of the battery cell 100. The end cover 12 and the housing 13 are not limited and may also be integrated. Specifically, the end cover 12 and the housing 13 may form a shared connection surface before other components are disposed inside the housing, and then the housing 13 is covered with the end cover 12 when the inside of the housing 13 needs to be enclosed. The housing 13 may be of various shapes and sizes, such as a cuboid shape, a cylindrical shape and a hexagonal prism shape. Specifically, the shape of the housing 13 may be determined according to a specific shape and size of the electrode assembly 11. The housing 13 may be made of various materials, such as copper, iron, aluminum, stainless steel, aluminum alloy and plastic, which are not particularly limited in the embodiments of this application.

The electrode assembly 11 is a component in which electrochemical reactions take place in the battery cell 100. The housing 13 may include one or more electrode assemblies 11 inside. The electrode assembly 11 is mainly formed by winding or stacking a positive electrode plate and a negative electrode plate, and a separator is generally provided between the positive electrode plate and the negative electrode plate. Parts of the positive electrode plate and the negative electrode plate with active substances of the electrode assembly 11 constitute a body portion of an electrode assembly, while parts of the positive electrode plate and the negative electrode plate without active substances separately constitute a tab 11a. A positive electrode tab and a negative electrode tab may both be located at one end of the body portion or be located at two ends of the body portion, respectively. During charging and discharging of a battery, a positive electrode active substance and a negative electrode active substance react with an electrolyte, and the tabs 11a are connected to electrode terminals to form a current loop. When lithium precipitation occurs, lithium dendrites puncture the separator, resulting in conduction between the positive electrode plate and the negative electrode plate of the electrode assembly in the electrode assembly, thus leading to a short circuit in the electrode assembly.

In the embodiments of this application, the battery cell 100 is a smallest unit constituting a battery group. In one battery group, a plurality of battery cells 100 may be provided. The plurality of battery cells 100 may be connected in series, parallel or series-parallel, where being connected in series-parallel means a combination of series connection and parallel connection of the plurality of battery cells 100. The plurality of battery cells 100 may be directly connected in series, parallel or series-parallel, and then an entirety of the plurality of battery cells 100 is accommodated in a box or another package to form an entirety capable of implementing charging and discharging externally.

In actual use, one battery group may be used as a battery for providing services. However, a plurality of battery groups may be connected in series, parallel or series-parallel to form an entirety that is accommodated in a box or another package as a battery for providing services. That is, in one battery, one or more battery groups may be provided.

Each battery cell 100 may be a secondary battery or a primary battery. The battery cell 100 may be cylindrical, flat, cuboid, or of other shapes.

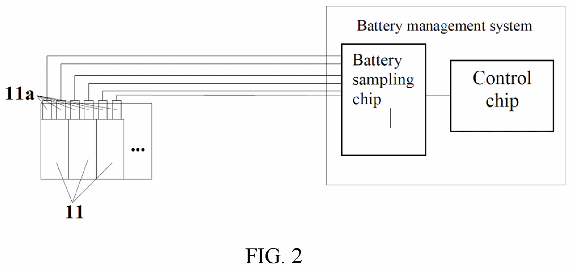

In addition, in actual use, the battery group usually cooperates with a battery management system to constitute a battery pack for providing services for an electric device, for example, as shown in FIG. 2. A battery sampling chip of the battery management system (for example, an AFE (analog front end, sensor analogue front end) chip in the battery management system) may be connected to the tab 11a of each electrode assembly 11 of the battery group, so as to acquire electrode assembly data including a voltage. Whereas a control chip of the battery management system (for example, a micro controller unit, MCU in the battery management system) may perform different strategies based on the data acquired by the battery sampling chip, thereby implementing battery management.

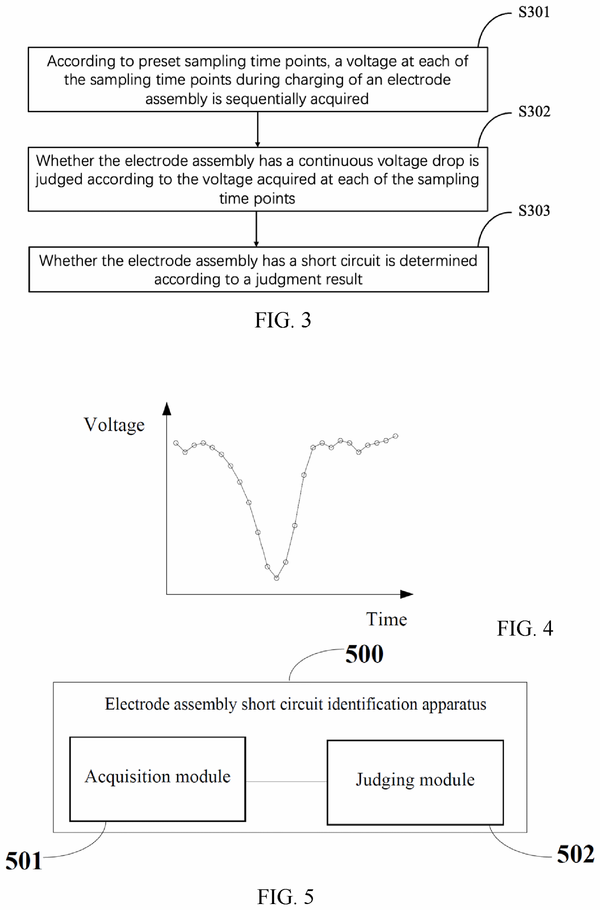

On the basis of the foregoing description, according to some embodiments of this application, as shown in FIG. 3, FIG. 3 is a basic flowchart of an electrode assembly short circuit identification method according to the embodiments of this application, where the method includes the following steps.

S301. According to preset sampling time points, a voltage at each of the sampling time points during charging of an electrode assembly is sequentially acquired.

In the embodiments of this application, a time interval between the sampling time points can be preset, so that a charging start time point is taken as a first sampling time point; and based on the preset time interval, voltage acquisition for the electrode assembly is sequentially performed to obtain the voltage of the electrode assembly at each of the sampling time points during charging.

It should be understood that theoretically, a shorter time interval between adjacent two of the sampling time points indicates a higher voltage sampling frequency for the electrode assembly, such that whether the electrode assembly has a continuous drop during charging can be discovered more easily. However, a shorter time interval imposes a higher requirement on a voltage acquisition device configured to acquire the voltage of the electrode assembly. In order to reliably judge whether the electrode assembly has a continuous voltage drop within a capability scope of the existing voltage acquisition devices, the applicants have found through lots of actual tests that under a condition that the time interval between adjacent two of the sampling time points is less than or equal to 0.1 second, a case of a continuous voltage drop caused by a short circuit of the electrode assembly can be effectively discovered, achieving desirable electrode assembly short circuit identification reliability. Therefore, in the embodiments of this application, the time interval between adjacent two of the sampling time points may be set to be less than or equal to 0.1 second. Exemplarily, the time interval between adjacent two of the sampling time points may be set to be 10 milliseconds to 50 milliseconds, for example, 30 milliseconds.

It should be further understood that an executive body of the electrode assembly short circuit identification method provided in the embodiments of this application may be the battery management system. The battery sampling chip of the battery management system may be connected to the positive and negative electrodes of each electrode assembly in the battery group so as to acquire the voltage of each electrode assembly. Therefore, in actual use, the time interval between adjacent two of the sampling time points may be set within a range less than or equal to 0.1 second according to an allowable working frequency range of the battery sampling chip of the battery management system, so as to balance a voltage sampling effect and performance requirements of the device.

S302. Whether the electrode assembly has a continuous voltage drop is judged according to the voltage acquired at each of the sampling time points.

It should be noted that in the embodiments of this application, the continuous voltage drop means that values of the voltages of the electrode assembly at at least three continuous sampling time points drop continuously. For example, a sampling time point 1, a sampling time point 2 and a sampling time point 3 are three continuous sampling time points. Assuming that the voltage values respectively acquired at the sampling time point 1, the sampling time point 2 and the sampling time point 3 are A1, A2 and A3, if A3 is less than A2 and A2 is less than A1, it can be determined that the electrode assembly has a continuous voltage drop at the sampling time point 1, the sampling time point 2 and the sampling time point 3.

It should be understood that in actual use, whether the electrode assembly has a continuous voltage drop can be determined based on whether the values of the voltages at the at least three continuous sampling time points drop continuously; besides, whether the electrode assembly has a continuous voltage drop can also be determined based on whether a variation value of the voltages at at least two adjacent sampling time points is less than 0.

For example, still assuming that the sampling time point 1, the sampling time point 2 and the sampling time point 3 are three continuous sampling time points, and that the voltage values respectively acquired at the sampling time point 1, the sampling time point 2 and the sampling time point 3 are A1, A2 and A3, during judging, if a variation value A2-A1 of the voltages at the sampling time point 2 and the sampling time point 1 is less than 0, and a variation value A3-A2 of the voltages at the sampling time point 3 and the sampling time point 2 is also less than 0, it can be determined that the electrode assembly has a continuous voltage drop at the sampling time point 1, the sampling time point 2 and the sampling time point 3.

It should be understood that the foregoing two methods for determining whether the electrode assembly has a continuous voltage drop are basically the same in essential principle, except that there are some differences in execution logics that need to be set when the methods are executed by a machine. In actual use, an engineer can configure a corresponding execution logic according to actual requirements so as to judge whether the electrode assembly has a continuous voltage drop.

In an optional implementation of the embodiments of this application, after charging is completed, whether the electrode assembly has a continuous voltage drop during charging can be determined according to a sampling time sequence of the sampling time points based on the voltages acquired at all of the sampling time points during charging.

Considering that in actual use, lithium precipitation usually happens during charging; a short circuit in an electrode assembly is usually caused when a separator is punctured by lithium dendrites formed due to lithium precipitation of the electrode assembly; and when a short circuit area expands to some extent, thermal runaway is triggered, resulting in serious battery safety accidents. Therefore, to reduce the risk of serious battery safety accidents such as thermal runaway during charging, in another optional implementation of the embodiments of this application, whether the electrode assembly has a continuous voltage drop can be judged continuously based on the latest acquired voltage of the electrode assembly at each sampling time point during charging, such that whether the electrode assembly has a short circuit is determined according to a judgment result during charging. In this way, once it is discovered that the electrode assembly has a short circuit during charging, control is performed to stop charging of all battery groups or to stop charging of the battery group where the electrode assembly with a short circuit is located, thereby reducing safety risks during charging and improving the safety in charging.

In the another optional implementation described in the above paragraph, as the corresponding voltage of the electrode assembly at the current sampling time point is newly acquired every time, judgment can be performed once again according to the above-described two methods for judging whether the electrode assembly has a continuous voltage drop, thereby determining whether the electrode assembly has a continuous voltage drop until the electrode assembly has been charged for a time reaching the current sampling time point.

To improve the judging efficiency and reduce expenses generated during judging, in the embodiments of this application, whether the electrode assembly has a continuous voltage drop is judged using a judging method implemented based on marking.

When the voltage of the electrode assembly is acquired at the current sampling time point, whether or not the voltage at the current sampling time point is lower than a voltage at a previous sampling time point that the current sampling time point follows is judged.

If the voltage at the current sampling time point is lower than the voltage at the previous sampling time point that the current sampling time point follows, whether a marked sampling time point is present is judged.

If no marked sampling time point is present, the previous sampling time point that the current sampling time point follows is marked.

If a marked sampling time point is present, it is determined that the electrode assembly has a continuous voltage drop from the marked sampling time point to the current sampling time point.

It should be noted that if the voltage at the current sampling time point is greater than or equal to the voltage at the previous sampling time point that the current sampling time point follows, whether a marked sampling time point is present is judged. If a marked sampling time point is present, the mark of the sampling time point is deleted.

In the foregoing method, once there is a voltage drop during charging, a sampling time point at a start position in the two sampling time points at which the voltage drop occurs is marked, and the mark is to be deleted when there is a voltage rise hereafter. In this way, every time when there is a voltage drop, whether the electrode assembly has a continuous voltage drop can be determined according to whether a marked sampling time point is present. Specifically, according to the foregoing method, if the voltage at the current sampling time point is less than the voltage at the previous sampling time point that the current sampling time point follows and a marked sampling time point is present, whether the electrode assembly has a continuous voltage drop can be determined quickly, and it can be further determined that the electrode assembly has a continuous voltage drop from the marked sampling time point to the current sampling time point.

S303. Whether the electrode assembly has a short circuit is determined according to a judgment result.

Considering that in actual use, during voltage acquisition of an electrode assembly, acquired data may fluctuate to some extent due to limitation of acquisition accuracy of an acquisition device, a situation that the electrode assembly is normal but an acquired voltage of the electrode assembly shows a small continuous drop may occur. Therefore, to reduce the possibility of mis-identification, in an optional implementation of the embodiments of this application, under a condition that it is judged that the electrode assembly has a continuous voltage drop, whether or not a continuous voltage drop amplitude of the electrode assembly is greater than a preset voltage fluctuation range can be judged; and if the continuous voltage drop amplitude of the electrode assembly is greater than the preset voltage fluctuation range, it is determined that the electrode assembly has a short circuit; otherwise, it is determined that the electrode assembly has no short circuit in this continuous voltage drop stage.

Exemplarily, in the foregoing optional implementation, the voltage fluctuation range may be set by an engineer according to actual requirements, for example, may be set as voltage acquisition accuracy of the battery management system. This can exclude a case of continuous voltage drop of the electrode assembly caused by the acquisition accuracy of the acquisition device as well as identify a short circuit of the electrode assembly in time, thereby reducing the risk of missing inspection of a short circuit of the electrode assembly and improving the reliability for identifying whether the electrode assembly has a short circuit.

Certainly, the voltage fluctuation range may be set to be a value greater than or less than the voltage acquisition accuracy of the battery management system, which is not limited in the embodiments of this application.

It should be understood that for the foregoing optional implementation, if the step S302 is implemented using the judging method implemented based on marking as described hereinbefore, under a condition that the electrode assembly has a continuous voltage drop, a difference value between a voltage at the marked sampling time point and the voltage at the current sampling time point can be calculated, and then whether the difference value is greater than the preset voltage fluctuation range is judged. If the difference value is greater than the preset voltage fluctuation range, it is determined that the electrode assembly has a short circuit. Otherwise, voltages at subsequent sampling time points continue to be acquired for rejudging.

Whereas in another optional implementation of the embodiments of this application, it can also be determined that the electrode assembly has a short circuit under a condition that the electrode assembly has a continuous voltage drop. In this way, a short circuit of the electrode assembly can be effectively discovered, avoiding serious battery safety accidents caused by the short circuit of the electrode assembly.

It should be noted that for one electrode assembly, with continuous proceeding of charging, a temperature rise may occur in the electrode assembly; therefore, for a defective electrode assembly with lithium precipitation generated, lithium dendrites may be molten under a high temperature, resulting in disappear of a short circuit in the electrode assembly, and leading to a voltage rise after a continuous voltage drop. Therefore, in the embodiments of this application, a defective electrode assembly with a short circuit can be determined as along as a short circuit is detected once in the electrode assembly during charging.

In the embodiments of this application, after it is determined that the electrode assembly has a short circuit, the electrode assembly may also be marked, thereby helping an engineer to perform processing such as disassembling and replacement on the electrode assembly in the battery group based on marking later.

In the embodiments of this application, the method for marking the electrode assembly may include but is not limited to the following methods: a unique identifier of the electrode assembly may be recorded for marking the electrode assembly.

In the embodiments of this application, the unique identifier of the electrode assembly may be an identifier of the battery group where the electrode assembly is located as well as coordinates of the electrode assembly in the battery group, such that the battery group where the defective electrode assembly is located can be accurately found out based on the identifier of the battery group, and thus the defective electrode assembly is accurately found out from the battery group based on the coordinates of the electrode assembly in the battery group. In addition, the unique identifier of the electrode assembly may alternatively be a unique code of each electrode assembly, such that location of the defective electrode assembly can be searched based on the unique code and related records about mounting of the electrode assembly.

For ease of understanding of the solution provided by the embodiments of this application, the following further illustratively describes this application by using a specific implementation process for identifying an electrode assembly short circuit on an electric vehicle as an example.

The battery management system detects whether the electrode assembly, the battery pack or the whole vehicle is in a gun-inserted state (that is, a charging gun-inserted state). If the electrode assembly, the battery pack or the whole vehicle is in a gun-inserted state, the battery pack starts to be charged.

During charging, the battery management system (assuming that the voltage acquisition accuracy of the battery management system is ΔV0 (for example, may be 2 mV)) continuously acquires the voltage of each electrode assembly according to a preset time interval Δt (Δt ≤ 0.1s) and calculates whether the voltage at the current sampling time point has a drop in comparison with the voltage at the previous sampling time point in real time.

If the voltage at the current sampling time point has no drop in comparison with the voltage at the previous sampling time point, whether a marked sampling time point is present is judged. If a marked sampling time point is present, the mark is deleted.

Depending on whether the voltage at the current sampling time point has a drop in comparison with the voltage at the previous sampling time point, whether a marked sampling time point is present is judged.

If no marked sampling time point is present, the previous sampling time point that the current sampling time point follows is marked.

If a marked sampling time point is present, a difference value ΔVt of the voltage at the current sampling time point and the voltage at the marked sampling time point is calculated. If ΔVt > ΔV0, it is determined that a short circuit occurs in the electrode assembly.

Exemplarily, electrode assembly voltage variation shown in FIG. 4 is used as an example, in this example, if a voltage drop is discovered at the second sampling time point for the first time, the first sampling time point is marked. If the voltage rises at the two sampling time points, the mark of the first sampling time point is deleted.

Then, if a voltage drop is discovered again at the fifth sampling time point, the fourth sampling time point is marked.

Subsequently, if a voltage drop is discovered at the sixth sampling time point and a marked sampling time point is present, a difference value ΔV₆₋₄ of a voltage at the sixth sampling time point and a voltage at the fourth sampling time point is calculated. Assuming that ΔV₆₋₄ is less than ΔV0, a voltage at the seventh sampling time point continues to be acquired and judged.

Assuming that a corresponding voltage difference value ΔV₉₋₄ at the ninth sampling time point in FIG. 4 is greater than ΔV0, it can be determined that a short circuit occurs in the electrode assembly after a corresponding voltage at the ninth sampling time point is acquired.

After that, the voltage still drops after the ninth sampling time point in FIG. 4, but the foregoing calculation and judgment are not required at the subsequent sampling time points after it is determined that a short circuit occurs in the electrode assembly.

After it is determined that there is an electrode assembly with a short circuit inside, charging is stopped, and a user can be informed to pull out a charging gun.

Based on the same inventive concept, an embodiment of this application further provides an electrode assembly short circuit identification apparatus 500. Referring to FIG. 5, FIG. 5 illustrates an electrode assembly short circuit identification apparatus using the method shown in FIG. 3. It should be understood that specific functions of the apparatus 500 refer to the foregoing description. To avoid repetition, detailed description is appropriately omitted. The apparatus 500 includes at least one software function module that is stored in a memory in a form of software or firmware or cured in an operating system or firmware of the apparatus 500. Specifically,
as shown in FIG. 5, the apparatus 500 includes: an acquisition module 501 and a judging module 502; where
the acquisition module 501 is configured to sequentially acquire, according to preset sampling time points, a voltage at each of the sampling time points during charging of an electrode assembly; and
the judging module 502 is configured to judge whether the electrode assembly has a continuous voltage drop according to the voltage acquired at each of the sampling time points and determine whether the electrode assembly has a short circuit according to a judgment result.

In a feasible implementation of the embodiment of this application, the judging module 502 is specifically configured to: determine that the electrode assembly has a short circuit under a condition that the electrode assembly has a continuous voltage drop.

In another feasible implementation of the embodiment of this application, the judging module 502 is specifically configured to: under a condition that the electrode assembly has a continuous voltage drop, judge whether or not a continuous voltage drop amplitude of the electrode assembly is greater than a preset voltage fluctuation range; and if the continuous voltage drop amplitude of the electrode assembly is greater than the preset voltage fluctuation range, determine that the electrode assembly has a short circuit.

In the above feasible implementation, the voltage fluctuation range is voltage acquisition accuracy of a battery management system.

In the embodiment of this application, the judging module 502 is specifically configured to: under a condition that the voltage of the electrode assembly is acquired at a current sampling time point, judge whether or not the voltage at the current sampling time point is lower than a voltage at a previous sampling time point that the current sampling time point follows; if the voltage at the current sampling time point is lower than the voltage at the previous sampling time point that the current sampling time point follows, judge whether a marked sampling time point is present; if no marked sampling time point is present, mark the previous sampling time point; and if a marked sampling time point is present, determine that the electrode assembly has a continuous voltage drop from the marked sampling time point to the current sampling time point.

In the above embodiment, the judging module 502 is further configured to: if the voltage at the current sampling time point is higher than or equal to the voltage at the previous sampling time point that the current sampling time point follows, judge whether a marked sampling time point is present; and if a marked sampling time point is present, delete the mark of the sampling time point.

In above embodiment, the judging module 502 is specifically configured to: under a condition that the electrode assembly has a continuous voltage drop, calculate a difference value between a voltage at the marked sampling time point and the voltage at the current sampling time point; judge whether the difference value is greater than the preset voltage fluctuation range; and if the difference value is greater than the preset voltage fluctuation range, determine that the electrode assembly has a short circuit.

In the embodiment of this application, a time interval between adjacent two of the sampling time points is less than or equal to 0.1 second.

In this embodiment of this application, the electrode assembly short circuit identification apparatus 500 further includes a control module, configured to stop charging of all battery groups after determining that the electrode assembly has a short circuit; or configured to stop charging of a battery group where the electrode assembly is located after determining that the electrode assembly has a short circuit.

In the embodiment of this application, the electrode assembly short circuit identification apparatus 500 further includes a marking module, configured to mark the electrode assembly after determining that the electrode assembly has a short circuit.

It should be understood that for brevity of description, some of the content described in the foregoing method part is not repeated in the apparatus part.

An embodiment of this application further provides a battery management system and a battery pack. As shown in FIG. 2, the battery pack may include a battery group and a battery management system. The battery group includes a plurality of electrode assemblies, and each of the electrode assemblies is connected to a battery sampling chip of the battery management system.

The battery management system may include: the battery sampling chip and a control chip, where
the battery sampling chip is configured to be connected to each electrode assembly of the battery group so as to sequentially acquire, according to preset sampling time points, a voltage at each of the sampling time points during charging of the electrode assembly. The control chip is in communication connection with the battery sampling chip and configured to judge whether the electrode assembly has a continuous voltage drop according to the voltage acquired at each of the sampling time points and determine whether the electrode assembly has a short circuit according to a judgment result.

It should be understood that in the embodiment of this application, the battery sampling chip may be a component such as an AFE having an electrode assembly voltage acquisition function in the battery management system, and the control chip may be a component such as an MCU having a data processing function in the battery management system, which is not construed as a limitation.

It should be further understood that in the embodiment of this application, the control chip can judge whether the electrode assembly has a continuous voltage drop and determine whether the electrode assembly has a short circuit according to the specific method described in the foregoing method part, which is not repeated herein.

An embodiment of this application further provides an electric device, and the electric device includes the foregoing battery pack.

It should be noted that in the embodiment of this application, the electric device may be but is not limited to a mobile phone, a tablet, a laptop, an electric toy, an electric tool, an electric scooter, an electric vehicle, a ship, a spacecraft, and the like. The electric toy may include a fixed or mobile electric toy, for example, a game console, an electric toy car, an electric toy ship, and an electric toy airplane. The spacecraft may include an airplane, a rocket, a space shuttle, a spaceship, and the like.

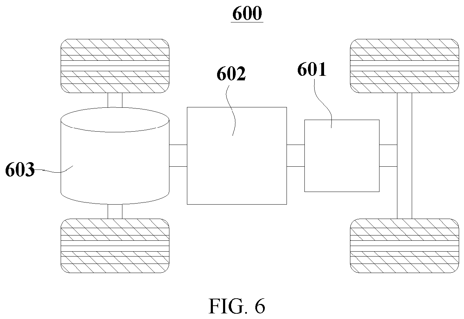

Exemplarily, as shown in FIG. 6, FIG. 6 illustrates a schematic structural diagram of an electric device being a vehicle 600. The vehicle 600 may be a fossil fuel vehicle, a natural-gas vehicle, or a new energy vehicle, and the new energy vehicle may be a battery electric vehicle, a hybrid electric vehicle, a range-extended vehicle, or the like. A battery pack is provided in the vehicle 600; a battery group 601 in the battery pack may be provided at the bottom, head, or tail of the vehicle 600; whereas the battery management system 602 in the battery pack may be provided around the battery pack 60 or provided in a region in the vehicle 600 other than a region where the battery group 601 is located. For example, the battery group 601 may be provided at the bottom of the vehicle 600, whereas the battery management system 602 may be provided at the head of the vehicle 600.

The battery group 601 may be configured to supply power to the vehicle 600. For example, the battery group 601 may be used as an operational power source for the vehicle 600. The vehicle 600 may further include a motor 603, and the battery management system 602 may be further configured to control the battery group 601 to supply power to the motor 603, for example, to meet working power needs of start, navigation, and driving of the vehicle 600.

In some embodiments of this application, the battery group 601 can be used as not only the operational power source for the vehicle 600 but also a driving power source for the vehicle 600, replacing or partially replacing fossil fuel or natural gas to provide driving traction for the vehicle 600.

An embodiment of this application further provides a computer-readable storage medium such as a floppy disc, an optical disc, a hard disc, a flash memory, a USB flash disc, a secure digital memory card, SD card, a multimedia card, MMC. The computer-readable storage medium stores one or more program instructions for implementing the foregoing steps, and the one or more program instructions can be executed by the battery management system, so that the foregoing electrode assembly short circuit identification method is implemented. This is not repeated herein.

Finally, it should be noted that: The foregoing embodiments are merely intended to describe the technical solutions of this application rather than to limit the technical solutions. Although this application is described in detail with reference to the foregoing embodiments, persons of ordinary skill in the art should understand that: they may still make modifications to the technical solutions described in the foregoing examples as long as these modifications do not depart from the scope of the technical solutions of the embodiments. In particular, as long as there is no structural or step conflict, the various technical features mentioned in the embodiments can be combined in any manner. This application is not limited to the specific embodiments disclosed in this specification, but includes all technical solutions falling within the scope of the claims.

## Claims

1. An electrode assembly short circuit identification method, comprising:
according to preset sampling time points, sequentially acquiring a voltage at each of the sampling time points during charging of an electrode assembly (11);
judging whether the electrode assembly (11) has a continuous voltage drop according to the voltage acquired at each of the sampling time points; and
determining whether the electrode assembly (11) has a short circuit according to a judgment result;
wherein the determining whether the electrode assembly (11) has a continuous voltage drop according to the voltage acquired at each of the sampling time points comprises:
under a condition that the voltage of the electrode assembly (11) is acquired at a current sampling time point, judging whether or not the voltage at the current sampling time point is lower than a voltage at a previous sampling time point that the current sampling time point follows; **characterized in that**
the determining whether the electrode assembly (11) has a continuous voltage drop according to the voltage acquired at each of the sampling time points further comprises:
if the voltage at the current sampling time point is lower than the voltage at the previous sampling time point that the current sampling time point follows, judging whether a marked sampling time point is present, wherein the marked sampling time point is earlier than the previous sampling time point and a voltage at the marked sampling time point is higher than the voltage at the previous sampling time point;
if no marked sampling time point is present, marking the previous sampling time point; and
if a marked sampling time point is present, determining that the electrode assembly (11) has a continuous voltage drop from the marked sampling time point to the current sampling time point.

2. The electrode assembly short circuit identification method according to claim 1, wherein the determining whether the electrode assembly (11) has a short circuit according to a judgment result comprises:
determining that the electrode assembly (11) has a short circuit under a condition that the electrode assembly has a continuous voltage drop.

3. The electrode assembly short circuit identification method according to claim 1, wherein the determining whether the electrode assembly (11) has a short circuit according to a judgment result comprises:
under a condition that the electrode assembly (11) has a continuous voltage drop, judging whether or not a continuous voltage drop amplitude of the electrode assembly (11) is greater than a preset voltage fluctuation range; and
if the continuous voltage drop amplitude of the electrode assembly is greater than the preset voltage fluctuation range, determining that the electrode assembly has a short circuit.

4. The electrode assembly short circuit identification method according to claim 3, wherein the voltage fluctuation range is voltage acquisition accuracy of a battery management system (602).

5. The electrode assembly short circuit identification method according to claim 1, wherein the method further comprises:
if the voltage at the current sampling time point is higher than or equal to the voltage at the previous sampling time point that the current sampling time point follows, judging whether a marked sampling time point is present; and
if a marked sampling time point is present, deleting the mark of the sampling time point.

6. The electrode assembly short circuit identification method according to claim 1, wherein the determining whether the electrode assembly (11) has a short circuit according to a judgment result comprises:
under a condition that the electrode assembly (11) has a continuous voltage drop, calculating a difference value between a voltage at the marked sampling time point and the voltage at the current sampling time point;
judging whether or not the difference value is greater than a preset voltage fluctuation range; and
if the difference value is greater than the preset voltage fluctuation range, determining that the electrode assembly has a short circuit.

7. The electrode assembly short circuit identification method according to any one of claims 1 to 6, wherein a time interval between adjacent two of the sampling time points is less than or equal to 0.1 second.

8. The electrode assembly short circuit identification method according to any one of claims 1 to 6, wherein the method further comprises:
after determining that the electrode assembly (11) has a short circuit, stopping charging of all battery groups (601);
or, after determining that the electrode assembly (11) has a short circuit, stopping charging of a battery group (601) where the electrode assembly (11) is located.

9. The electrode assembly short circuit identification method according to any one of claims 1 to 6, wherein the method further comprises:
after determining that the electrode assembly (11) has a short circuit, marking the electrode assembly (11).

10. An electrode assembly short circuit identification apparatus (500), **characterized by** comprising:
an acquisition module (501), configured to sequentially acquire, according to preset sampling time points, a voltage at each of the sampling time points during charging of an electrode assembly(11); and
a judging module (502), configured to judge whether the electrode assembly (11) has a continuous voltage drop according to the voltage acquired at each of the sampling time points and determine whether the electrode assembly (11) has a short circuit according to a judgment result, wherein the electrode assembly short circuit identification apparatus (500) is configured to implement the method according to any one of claims 1 to 9.

11. A battery management system (602), comprising
an apparatus (500) according to claim 10, wherein
the acquisition module (501) is a battery sampling chip configured to connect to each electrode assembly (11) of a battery group (601); and
the judging module (502) is a control chip in communication connection with the battery sampling chip.

12. A battery pack, **characterized by** comprising: a battery group (601), and the battery management system (602) according to claim 11, wherein
the battery group (601) comprises a plurality of electrode assemblies (11); and
each of the electrode assemblies (11) is connected to a battery sampling chip of the battery management system (602).

13. An electric device (600), **characterized by** comprising the battery pack according to claim 12.

14. A computer-readable storage medium, wherein the computer-readable storage medium stores one or more program instructions, and the program instructions when executed by a battery management system (602) according to claim 11, cause the battery management system (602) to perform the electrode assembly short circuit identification method according to any one of claims 1 to 9.

## Patentansprüche

1. Verfahren zum Identifizieren eines Kurzschlusses einer Elektrodenanordnung, umfassend:
sequentielles Erfassen einer Spannung zu jedem der Abtastzeitpunkte gemäß voreingestellten Abtastzeitpunkten während des Ladens einer Elektrodenanordnung (11);
Beurteilen, ob die Elektrodenanordnung (11) einen kontinuierlichen Spannungsabfall aufweist, anhand der zu jedem der Abtastzeitpunkte erfassten Spannung; und
Bestimmen, ob die Elektrodenanordnung (11) einen Kurzschluss aufweist, anhand eines Beurteilungsergebnisses;
wobei das Bestimmen, ob die Elektrodenanordnung (11) einen kontinuierlichen Spannungsabfall aufweist, anhand der zu jedem der Abtastzeitpunkte erfassten Spannung umfasst:
unter der Bedingung, dass die Spannung der Elektrodenanordnung (11) zu einem aktuellen Abtastzeitpunkt erfasst wird, Beurteilen, ob die Spannung zu dem aktuellen Abtastzeitpunkt niedriger als eine Spannung zu einem vorhergehenden Abtastzeitpunkt ist, auf den der aktuelle Abtastzeitpunkt folgt; **dadurch gekennzeichnet, dass**
das Bestimmen, ob die Elektrodenanordnung (11) einen kontinuierlichen Spannungsabfall aufweist, anhand der zu jedem der Abtastzeitpunkte erfassten Spannung ferner umfasst:
wenn die Spannung zu dem aktuellen Abtastzeitpunkt niedriger als die Spannung zu dem vorhergehenden Abtastzeitpunkt ist, auf den der aktuelle Abtastzeitpunkt folgt, Beurteilen, ob ein markierter Abtastzeitpunkt vorhanden ist, wobei der markierte Abtastzeitpunkt früher als der vorhergehende Abtastzeitpunkt ist und eine Spannung zu dem markierten Abtastzeitpunkt höher als die Spannung zu dem vorhergehenden Abtastzeitpunkt ist;
wenn kein markierter Abtastzeitpunkt vorhanden ist, Markieren des vorhergehenden Abtastzeitpunkts; und
wenn ein markierter Abtastzeitpunkt vorhanden ist, Bestimmen, dass die Elektrodenanordnung (11) einen kontinuierlichen Spannungsabfall von dem markierten Abtastzeitpunkt bis zu dem aktuellen Abtastzeitpunkt aufweist.

2. Verfahren zum Identifizieren eines Kurzschlusses einer Elektrodenanordnung nach Anspruch 1, wobei das Bestimmen, ob die Elektrodenanordnung (11) einen Kurzschluss aufweist, anhand eines Beurteilungsergebnisses umfasst:
Bestimmen, dass die Elektrodenanordnung (11) einen Kurzschluss aufweist, unter der Bedingung, dass die Elektrodenanordnung einen kontinuierlichen Spannungsabfall aufweist.

3. Verfahren zum Identifizieren eines Kurzschlusses einer Elektrodenanordnung nach Anspruch 1, wobei das Bestimmen, ob die Elektrodenanordnung (11) einen Kurzschluss aufweist, anhand eines Beurteilungsergebnisses umfasst:
unter der Bedingung, dass die Elektrodenanordnung (11) einen kontinuierlichen Spannungsabfall aufweist, Beurteilen, ob eine Amplitude des kontinuierlichen Spannungsabfalls der Elektrodenanordnung (11) größer als ein voreingestellter Spannungsschwankungsbereich ist; und
wenn die Amplitude des kontinuierlichen Spannungsabfalls der Elektrodenanordnung größer als der voreingestellte Spannungsschwankungsbereich ist, Bestimmen, dass die Elektrodenanordnung einen Kurzschluss aufweist.

4. Verfahren zum Identifizieren eines Kurzschlusses einer Elektrodenanordnung nach Anspruch 3, wobei der Spannungsschwankungsbereich eine Spannungserfassungsgenauigkeit eines Batteriemanagementsystems (602) ist.

5. Verfahren zum Identifizieren eines Kurzschlusses einer Elektrodenanordnung nach Anspruch 1, wobei das Verfahren ferner umfasst:
wenn die Spannung zu dem aktuellen Abtastzeitpunkt höher als oder gleich der Spannung zu dem vorhergehenden Abtastzeitpunkt ist, auf den der aktuelle Abtastzeitpunkt folgt, Beurteilen, ob ein markierter Abtastzeitpunkt vorhanden ist; und
wenn ein markierter Abtastzeitpunkt vorhanden ist, Löschen der Markierung des Abtastzeitpunkts.

6. Verfahren zum Identifizieren eines Kurzschlusses einer Elektrodenanordnung nach Anspruch 1, wobei das Bestimmen, ob die Elektrodenanordnung (11) einen Kurzschluss aufweist, anhand eines Beurteilungsergebnisses umfasst:
unter der Bedingung, dass die Elektrodenanordnung (11) einen kontinuierlichen Spannungsabfall aufweist, Berechnen eines Differenzwerts zwischen einer Spannung zu dem markierten Abtastzeitpunkt und der Spannung zu dem aktuellen Abtastzeitpunkt;
Beurteilen, ob der Differenzwert größer als ein voreingestellter Spannungsschwankungsbereich ist; und
wenn der Differenzwert größer als der voreingestellte Spannungsschwankungsbereich ist, Bestimmen, dass die Elektrodenanordnung einen Kurzschluss aufweist.

7. Verfahren zum Identifizieren eines Kurzschlusses einer Elektrodenanordnung nach einem der Ansprüche 1 bis 6, wobei ein Zeitintervall zwischen zwei benachbarten der Abtastzeitpunkte kleiner als oder gleich 0,1 Sekunden ist.

8. Verfahren zum Identifizieren eines Kurzschlusses einer Elektrodenanordnung nach einem der Ansprüche 1 bis 6, wobei das Verfahren ferner umfasst:
nach dem Bestimmen, dass die Elektrodenanordnung (11) einen Kurzschluss aufweist, Stoppen des Ladens aller Batteriegruppen (601);
oder nach dem Bestimmen, dass die Elektrodenanordnung (11) einen Kurzschluss aufweist, Stoppen des Ladens einer Batteriegruppe (601), in der sich die Elektrodenanordnung (11) befindet.

9. Verfahren zum Identifizieren eines Kurzschlusses einer Elektrodenanordnung nach einem der Ansprüche 1 bis 6, wobei das Verfahren ferner umfasst:
nach dem Bestimmen, dass die Elektrodenanordnung (11) einen Kurzschluss aufweist, Markieren der Elektrodenanordnung (11).

10. Vorrichtung zum Identifizieren eines Kurzschlusses einer Elektrodenanordnung (500), **dadurch gekennzeichnet, dass** sie umfasst:
ein Erfassungsmodul (501), das dazu ausgebildet ist, gemäß voreingestellten Abtastzeitpunkten sequentiell eine Spannung zu jedem der Abtastzeitpunkte während des Ladens einer Elektrodenanordnung (11) zu erfassen; und
ein Beurteilungsmodul (502), das dazu ausgebildet ist, anhand der zu jedem der Abtastzeitpunkte erfassten Spannung zu beurteilen, ob die Elektrodenanordnung (11) einen kontinuierlichen Spannungsabfall aufweist, und anhand eines Beurteilungsergebnisses zu bestimmen, ob die Elektrodenanordnung (11) einen Kurzschluss aufweist, wobei die Vorrichtung zum Identifizieren eines Kurzschlusses einer Elektrodenanordnung (500) dazu ausgebildet ist, das Verfahren nach einem der Ansprüche 1 bis 9 zu implementieren.

11. Batteriemanagementsystem (602), umfassend
eine Vorrichtung (500) nach Anspruch 10, wobei
das Erfassungsmodul (501) ein Batterieabtastchip ist, der dazu ausgebildet ist, mit jeder Elektrodenanordnung (11) einer Batteriegruppe (601) verbunden zu werden; und
das Beurteilungsmodul (502) ein Steuerchip ist, der in Kommunikationsverbindung mit dem Batterieabtastchip steht.

12. Batteriepack, **dadurch gekennzeichnet, dass** er umfasst: eine Batteriegruppe (601) und das Batteriemanagementsystem (602) nach Anspruch 11, wobei
die Batteriegruppe (601) eine Vielzahl von Elektrodenanordnungen (11) umfasst; und
jede der Elektrodenanordnungen (11) mit einem Batterieabtastchip des Batteriemanagementsystems (602) verbunden ist.

13. Elektrisches Gerät (600), **dadurch gekennzeichnet, dass** es den Batteriepack nach Anspruch 12 umfasst.

14. Computerlesbares Speichermedium, wobei das computerlesbare Speichermedium eine oder mehrere Programmanweisungen speichert, und die Programmanweisungen bei Ausführung durch ein Batteriemanagementsystem (602) nach Anspruch 11 das Batteriemanagementsystem (602) veranlassen, das Verfahren zum Identifizieren eines Kurzschlusses einer Elektrodenanordnung nach einem der Ansprüche 1 bis 9 durchzuführen.

## Revendications

1. Procédé d'identification de court-circuit d'un ensemble d'électrodes, comprenant :
l'acquisition séquentielle, selon des instants d'échantillonnage prédéfinis, d'une tension à chacun des instants d'échantillonnage pendant la charge d'un ensemble d'électrodes (11) ;
le fait de juger si l'ensemble d'électrodes (11) présente une chute de tension continue en fonction de la tension acquise à chacun des instants d'échantillonnage ; et
le fait de déterminer si l'ensemble d'électrodes (11) présente un court-circuit en fonction d'un résultat de jugement ;
dans lequel le fait de déterminer si l'ensemble d'électrodes (11) présente une chute de tension continue en fonction de la tension acquise à chacun des instants d'échantillonnage comprend :
à condition que la tension de l'ensemble d'électrodes (11) soit acquise à un instant d'échantillonnage actuel, le fait de juger si la tension à l'instant d'échantillonnage actuel est inférieure ou non à une tension à un instant d'échantillonnage précédent que suit l'instant d'échantillonnage actuel ; **caractérisé en ce que**
le fait de déterminer si l'ensemble d'électrodes (11) présente une chute de tension continue en fonction de la tension acquise à chacun des instants d'échantillonnage comprend en outre :
si la tension à l'instant d'échantillonnage actuel est inférieure à la tension à l'instant d'échantillonnage précédent que suit l'instant d'échantillonnage actuel, le fait de juger si un instant d'échantillonnage marqué est présent, dans lequel l'instant d'échantillonnage marqué est antérieur à l'instant d'échantillonnage précédent et une tension à l'instant d'échantillonnage marqué est supérieure à la tension à l'instant d'échantillonnage précédent ;
si aucun instant d'échantillonnage marqué n'est présent, le fait de marquer l'instant d'échantillonnage précédent ; et
si un instant d'échantillonnage marqué est présent, le fait de déterminer que l'ensemble d'électrodes (11) présente une chute de tension continue de l'instant d'échantillonnage marqué à l'instant d'échantillonnage actuel.

2. Procédé d'identification de court-circuit d'un ensemble d'électrodes selon la revendication 1, dans lequel le fait de déterminer si l'ensemble d'électrodes (11) présente un court-circuit en fonction d'un résultat de jugement comprend :
le fait de déterminer que l'ensemble d'électrodes (11) présente un court-circuit à condition que l'ensemble d'électrodes présente une chute de tension continue.

3. Procédé d'identification de court-circuit d'un ensemble d'électrodes selon la revendication 1, dans lequel le fait de déterminer si l'ensemble d'électrodes (11) présente un court-circuit en fonction d'un résultat de jugement comprend :
à condition que l'ensemble d'électrodes (11) présente une chute de tension continue, le fait de juger si une amplitude de chute de tension continue de l'ensemble d'électrodes (11) est supérieure ou non à une plage de fluctuation de tension prédéfinie ; et
si l'amplitude de chute de tension continue de l'ensemble d'électrodes est supérieure à la plage de fluctuation de tension prédéfinie, le fait de déterminer que l'ensemble d'électrodes présente un court-circuit.

4. Procédé d'identification de court-circuit d'un ensemble d'électrodes selon la revendication 3, dans lequel la plage de fluctuation de tension est une précision d'acquisition de tension d'un système de gestion de batterie (602).

5. Procédé d'identification de court-circuit d'un ensemble d'électrodes selon la revendication 1, dans lequel le procédé comprend en outre :
si la tension à l'instant d'échantillonnage actuel est supérieure ou égale à la tension à l'instant d'échantillonnage précédent que suit l'instant d'échantillonnage actuel, le fait de juger si un instant d'échantillonnage marqué est présent ; et
si un instant d'échantillonnage marqué est présent, le fait de supprimer le marquage de l'instant d'échantillonnage.

6. Procédé d'identification de court-circuit d'un ensemble d'électrodes selon la revendication 1, dans lequel le fait de déterminer si l'ensemble d'électrodes (11) présente un court-circuit en fonction d'un résultat de jugement comprend :
à condition que l'ensemble d'électrodes (11) présente une chute de tension continue, le fait de calculer une valeur de différence entre une tension à l'instant d'échantillonnage marqué et la tension à l'instant d'échantillonnage actuel ;
le fait de juger si la valeur de différence est supérieure ou non à une plage de fluctuation de tension prédéfinie ; et
si la valeur de différence est supérieure à la plage de fluctuation de tension prédéfinie, le fait de déterminer que l'ensemble d'électrodes présente un court-circuit.

7. Procédé d'identification de court-circuit d'un ensemble d'électrodes selon l'une quelconque des revendications 1 à 6, dans lequel un intervalle de temps entre deux instants d'échantillonnage adjacents est inférieur ou égal à 0,1 seconde.

8. Procédé d'identification de court-circuit d'un ensemble d'électrodes selon l'une quelconque des revendications 1 à 6, dans lequel le procédé comprend en outre :
après avoir déterminé que l'ensemble d'électrodes (11) présente un court-circuit, l'arrêt de la charge de tous les groupes de batteries (601) ;
ou, après avoir déterminé que l'ensemble d'électrodes (11) présente un court-circuit, l'arrêt de la charge d'un groupe de batteries (601) dans lequel se trouve l'ensemble d'électrodes (11).

9. Procédé d'identification de court-circuit d'un ensemble d'électrodes selon l'une quelconque des revendications 1 à 6, dans lequel le procédé comprend en outre :
après avoir déterminé que l'ensemble d'électrodes (11) présente un court-circuit, le marquage de l'ensemble d'électrodes (11).

10. Appareil d'identification de court-circuit d'un ensemble d'électrodes (500), **caractérisé en ce qu'**il comprend :
un module d'acquisition (501), configuré pour acquérir séquentiellement, selon des instants d'échantillonnage prédéfinis, une tension à chacun des instants d'échantillonnage pendant la charge d'un ensemble d'électrodes (11) ; et
un module de jugement (502), configuré pour juger si l'ensemble d'électrodes (11) présente une chute de tension continue en fonction de la tension acquise à chacun des instants d'échantillonnage et pour déterminer si l'ensemble d'électrodes (11) présente un court-circuit en fonction d'un résultat de jugement, dans lequel l'appareil d'identification de court-circuit d'un ensemble d'électrodes (500) est configuré pour mettre en œuvre le procédé selon l'une quelconque des revendications 1 à 9.

11. Système de gestion de batterie (602), comprenant
un appareil (500) selon la revendication 10, dans lequel
le module d'acquisition (501) est une puce d'échantillonnage de batterie configurée pour se connecter à chaque ensemble d'électrodes (11) d'un groupe de batteries (601) ; et
le module de jugement (502) est une puce de commande en connexion de communication avec la puce d'échantillonnage de batterie.

12. Bloc-batterie, **caractérisé en ce qu'**il comprend : un groupe de batteries (601), et le système de gestion de batterie (602) selon la revendication 11, dans lequel
le groupe de batteries (601) comprend une pluralité d'ensembles d'électrodes (11) ; et
chacun des ensembles d'électrodes (11) est connecté à une puce d'échantillonnage de batterie du système de gestion de batterie (602).

13. Dispositif électrique (600), **caractérisé en ce qu'**il comprend le bloc-batterie selon la revendication 12.

14. Support de stockage lisible par ordinateur, dans lequel le support de stockage lisible par ordinateur stocke une ou plusieurs instructions de programme, et les instructions de programme, lorsqu'elles sont exécutées par un système de gestion de batterie (602) selon la revendication 11, amènent le système de gestion de batterie (602) à exécuter le procédé d'identification de court-circuit d'un ensemble d'électrodes selon l'une quelconque des revendications 1 à 9.
